(19)

**Europäisches Patentamt**
**European Patent Office**
**Office européen des brevets**

(11) **EP 4 739 063 A1**

(12) **EUROPEAN PATENT APPLICATION**

(43) Date of publication:
06.05.2026 Bulletin 2026/19

(21) Application number: 25207359.8

(22) Date of filing: 07.10.2025

(51) International Patent Classification (IPC):
*H10W 20/41* (2026.01)  *H10B 20/25* (2023.01)
*H10W 20/43* (2026.01)  *H10B 69/00* (2023.01)

(52) Cooperative Patent Classification (CPC):
**H10W 20/423; H10B 20/25; H10B 41/60;**
**H10B 69/00; H10W 20/43**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH LA MA MD TN**

(30) Priority: 31.10.2024 US 202418932778

(71) Applicant: **MEDIATEK INC.**
**Hsinchu City 30078 (TW)**

(72) Inventors:
• WU, Yu-Sheng
  **30078 Hsinchu City (TW)**
• JI, Yan-Liang
  **30078 Hsinchu City (TW)**

(74) Representative: **Haseltine Lake Kempner LLP**
**Cheapside House**
**138 Cheapside**
**London EC2V 6BJ (GB)**

(54) **SEMICONDUCTOR STRUCTURE**

(57) A semiconductor structure is provided. The semiconductor structure includes a substrate, electronic devices, and an interconnection structure. The electronic devices are disposed on the substrate. The electronic devices includes first gate structures. The interconnection structure including a first interconnection-level conductive trace is located directly above the electronic devices. The first interconnection-level conductive trace has first openings for exposing at least one of the first gate structures.

FIG. 1

## Description

## BACKGROUND OF THE DISCLOSURE

## Field of the Disclosure

The present disclosure relates to a semiconductor structure, and, in particular, to the layout of an interconnection-level conductive trace of a semiconductor structure.

## Description of the Related Art

During the process of fabricating semiconductor devices such as transistors and memories, unwanted charges may be trapped in a gate oxide layer. These trapped charges may have negative effects on the threshold voltage of the transistor, the program and erase threshold of the memory, the switching speed of the transistor, and the program and erase speed of the memory, for example.

Therefore, a novel semiconductor structure is needed.

## BRIEF SUMMARY OF THE DISCLOSURE

An embodiment of the disclosure provides a semiconductor structure. The semiconductor structure includes a substrate, electronic devices, and an interconnection structure. The electronic devices are disposed on the substrate. The electronic devices includes first gate structures. The interconnection structure including a first interconnection-level conductive trace is located directly above the electronic devices. The first interconnection-level conductive trace has first openings for exposing at least one of the first gate structures.

## BRIEF DESCRIPTION OF THE DRAWINGS

The present disclosure can be more fully understood by reading the subsequent detailed description and examples with references made to the accompanying drawings, wherein:

FIG. 1 is a schematic cross-sectional view of a semiconductor structure in accordance with some embodiments of the disclosure;
FIG. 2 is a schematic cross-sectional view of a semiconductor structure in accordance with some embodiments of the disclosure;
FIG. 3 is a schematic top view of the semiconductor structure of FIG. 1 or FIG. 2 in accordance with some embodiments of the disclosure, showing the arrangements of openings of an interconnection-level conductive trace of an interconnection structure and the relative positions between the openings of the interconnection-level conductive trace and gate electrodes of electronic devices; and

FIGS. 4, 5, 6, 7 and 8 are schematic top views of the interconnection-level conductive trace of the semiconductor structure of FIG. 1 or FIG. 2 in accordance with some embodiments of the disclosure, showing various shapes of the openings of the interconnection-level conductive trace of the interconnection structure.

## DETAILED DESCRIPTION OF THE DISCLOSURE

The following description is made for the purpose of illustrating the general principles of the disclosure and should not be taken in a limiting sense. The scope of the disclosure is best determined by reference to the appended claims.

In order to remove the unwanted charges trapped in the gate oxide layers of the semiconductor devices, UV light is usually used to irradiate the transistors and memories after the fabrication of the semiconductor devices. However, the conventional metal routings above the semiconductor devices having gate oxide (GOX) sensitive regions need to be rearranged in other locations to avoid blocking UV light. The rearranged metal routings may cause an increase in the device area and will not facilitate the scaling of the semiconductor devices.

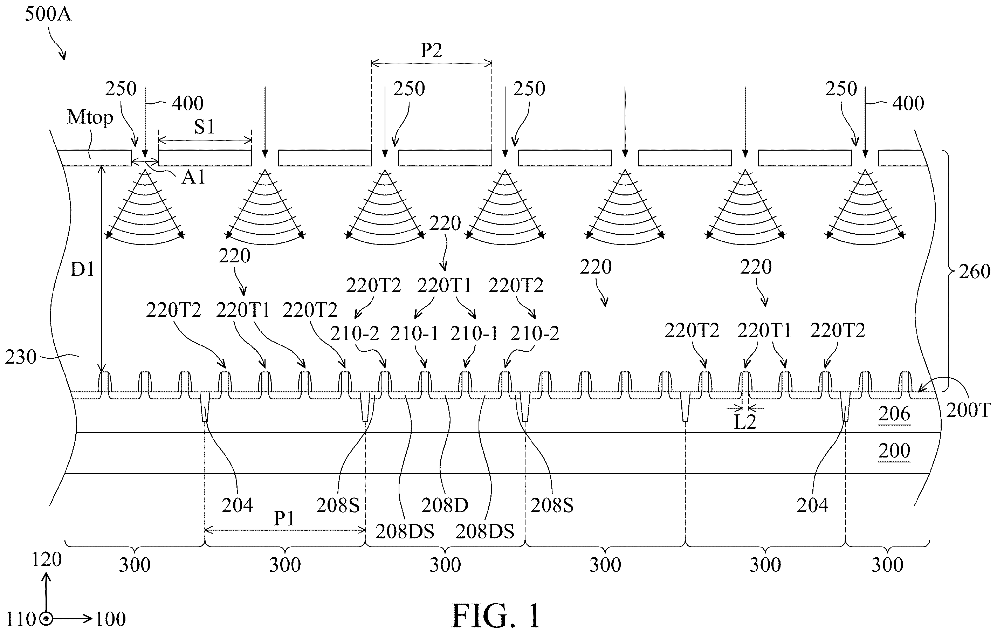

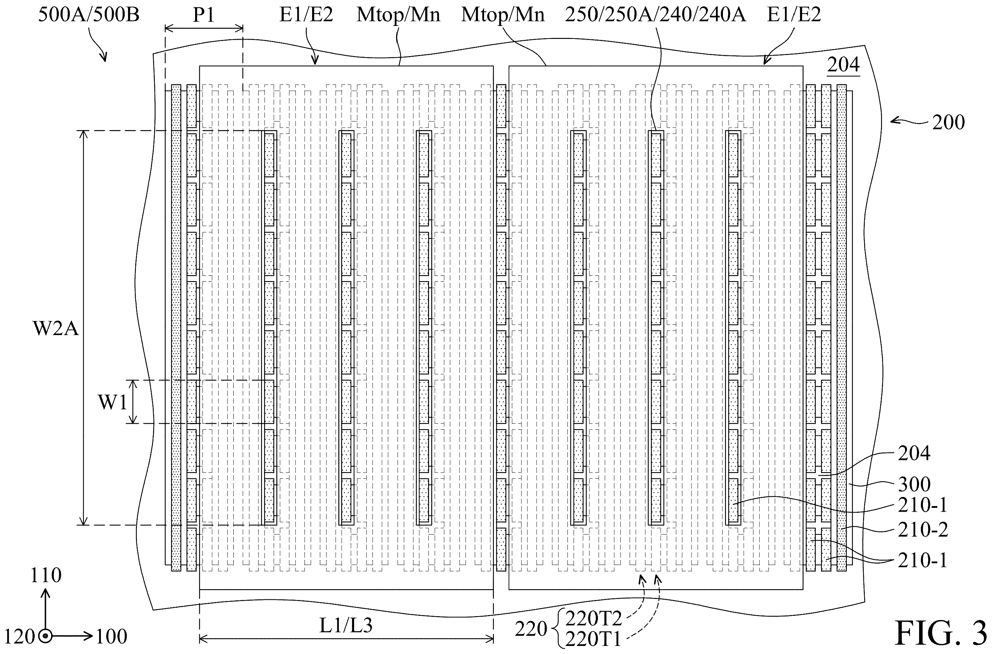

FIG. 1 is a schematic cross-sectional view of a semiconductor structure 500A in accordance with some embodiments of the disclosure. FIG. 3 is a schematic top view of the semiconductor structure 500A of FIG. 1 in accordance with some embodiments of the disclosure, showing the arrangements of openings 250 of a first interconnection-level conductive trace Mtop of an interconnection structure 260 and the relative positions between the openings 250 of the first interconnection-level conductive trace Mtop and gate structures 210-1 of electronic devices 220. FIG. 3 only show some features for illustration, and the remaining features may be shown in the cross-sectional views of FIG. 1. In FIG. 1 and the following figures, a direction 100 may be referred to as a channel length direction, a direction 110 may be referred to as a channel width direction, and a direction 120 may be referred to as a device height direction. The directions 100 and 110 are substantially parallel to a top surface 200T of a substrate 200 of the semiconductor structure 500A. The direction 120 is substantially perpendicular to the top surface 200T of the substrate 200 of the semiconductor structure 500A.

In some embodiments, the semiconductor structure 500A is applied in logic devices, memory devices or other applicable active devices or passive devices. In some embodiments as shown in FIG. 1, the semiconductor structure 500A is applied in memory devices such as one-time programmable (OTP) memory devices. In some embodiments, the semiconductor structure 500A includes the substrate 200, electronic devices 220 and an interconnection structure 260.

As shown in FIG. 1, the substrate 200 has an active region 300 surrounded by isolation features 204. In some embodiments, the substrate 200 includes a semiconductor wafer or a silicon on insulator (SOI) wafer. The substrate 200 may be doped with dopants of p-type or n-type according to a predetermined design rule.

The semiconductor structure 500A may further include a well region 206 formed within the active region 300 in the substrate 200. In some embodiments, the well region 206 may be doped with dopants having a first conductivity type. In some embodiments in which the semiconductor structure 500A includes a P-type oxide-semiconductor field effect-based (PMOS-based) OTP memory device, the well region 206 is, for example, an N-type well region.

The electronic devices 220 are disposed on the active region 300 of the substrate 200. As shown in FIG. 1, the two adjacent electronic devices 220 in mirror symmetry may form a unit cell. The unit cells of the electronic devices 220 may be arranged as an array along the direction 100 and the 110. In addition, the unit cells of the electronic devices 220 may be arranged in the direction 100 with a cell pitch P1.

In some embodiments in which the electronic device 220 includes a one-time programmable (OTP) memory device, the electronic device 220 includes a floating gate transistor 220T1 and a select transistor 220T2 connected in series in the same active region 300.

In some embodiments as shown in FIG. 1, the floating gate transistor 220T1 is disposed on the well region 206 and includes a gate structure 210-1, a source/drain doped region 208DS and a source/drain doped region 208D. The gate structure 210-1 is disposed within the active region 300 on the substrate 200 and extends in the direction 110. The direction 110 may serve as an extending direction of the gate structure 210-1. In some embodiments, the gate structure 210-1 includes a gate insulating layer (not shown) and a gate electrode layer (not shown). The gate insulating layer is formed on the substrate 200. The gate electrode layer is formed on the gate insulating layer. In addition, gate spacers (not shown) are formed on the opposite sides of the gate electrode layer. Since the erase and programming performances of the OTP memory device are sensitive to the trapped charges in gate insulating layer of the gate structures 210-1. Therefore, the gate structure 210-1 is located in the gate oxide (GOX) sensitive region.

The source/drain doped region 208DS and the source/drain doped region 208D are located within the same active region 300 in the substrate 200. The source/drain doped region 208DS and the source/drain doped region 208D are disposed on the well region 206 and on opposite sides of the gate structure 210-1 along the direction 100. In some embodiments, source/drain doped region 208DS and the source/drain doped region 208D may be doped with dopants having a second conductivity type opposite to the first conductivity type. For example, when the well region 206 is N-type, the source/drain doped region 208DS and the source/drain doped region 208D are P-type.

The select transistor 220T2 is disposed on the well region 206 and includes a gate structure 210-2, a source/drain doped region 208S and the source/drain doped region 208DS. The gate structure 210-2 is disposed within the active region 300 on the substrate 200. In addition, the gate structure 210-2 is located beside the first gate structure 210-1 of the floating gate transistor 220T1 along the direction 100. In some embodiments, the gate structures 210-1 and 210-2 may have the same or similar structures and formed in the same process(es).

The source/drain doped region 208S and the source/drain doped region 208DS are located within the same active region 300 in the substrate 200. The source/drain doped region 208S and the source/drain doped region 208DS are disposed on the well region 206 and on opposite sides of the gate structure 210-2 along the direction 100. In addition, the source/drain doped region 208DS of the floating gate transistor 220T1 is commonly used as the source/drain doped region of the select transistor 220T2 opposite the source/drain doped region 208S. In some embodiments, the source/drain doped region 208S may be doped with dopants having the second conductivity type opposite to the first conductivity type. For example, when the well region 206 is N-type, the source/drain doped region 208S is P-type.

The interconnection structure 260 is formed over the substrate 200. In addition, the interconnection structure 260 covers the electronic devices 220. In addition, the interconnection structure 260 is configured electrically connected to various terminals of the electronic devices 220. In some embodiments, the interconnection structure 260 includes a dielectric layer structure 230, interconnection-level conductive traces including a first interconnection-level conductive trace Mtop and conductive vias (not shown). In some embodiments, each layer of the interconnection-level conductive traces may include one or more conductive traces. For example, the topmost layer conductive trace may include the first interconnection-level conductive trace Mtop and other conductive trace(s).

The dielectric layer structure 230 is vertically stacked on the substrate 200 and the electronic devices 220. The dielectric layer structure 230 may be a single layer structure or a multi-layer structure. In some embodiments, the dielectric layer structure 230 includes silicon oxide, silicon oxynitride, un-doped silicate glass (USG), borosilicate glass (BSG), phosphoric silicate glass (PSG), borophosphosilicate glass (BPSG), fluorinated silicate glass (FSG), carbon doped oxide, porous carbon doped silicon dioxide, a polymer such as polyimide or silicon oxycarbide polymer (SiOC), or combinations thereof. In some embodiments, the dielectric layer structure 230 is formed by chemical vapor deposition (CVD), physical vapor deposition, (PVD), atomic layer deposition (ALD) or other applicable deposition processes.

The interconnection-level conductive traces may be laterally (e.g., along the direction 100) formed in the dielectric layer structure 230. In some embodiments, the interconnection-level conductive traces may include a bottommost interconnection-level conductive trace through a topmost interconnection-level conductive trace. In this embodiment, the first interconnection-level conductive trace Mtop is the topmost interconnection-level conductive trace.

The conductive vias (not shown) are vertically (e.g., along the direction 120) formed the dielectric layer structure 230 and connected between the first interconnection-level conductive trace Mtop and the neighboring interconnection-level conductive traces (not shown). In some embodiments, the interconnection-level conductive traces and conductive vias include a conductive material, such as copper (Cu), aluminum (Al), tungsten (W), titanium (Ti), titanium nitride (TiN), tantalum (Ta), tantalum nitride (TaN) , or the alloys thereof.

According to the design rule, the first interconnection-level conductive trace Mtop, such as the topmost interconnection-level conductive trace, may have the maximum trace width than the lower interconnection-level conductive traces. As shown in FIGS. 1 and 3, the first interconnection-level conductive trace Mtop may be located directly above and covering the electronic devices 220. Of course, it is understandable that other materials may be present between the first interconnection-level conductive trace Mtop and the electronic devices 220, such as dielectric layers, conductive trace layers, etc. The electronic devices 220 may be located within a projection of an outer edge E1 of the topmost interconnection-level conductive trace on the top surface 200T of the substrate 200. In some embodiments, the first interconnection-level conductive trace Mtop has a dimension L1 in the direction 100. In some embodiments, the dimension L1 is greater than 10 $\mu$m. In some embodiments, a ratio of the dimension L1 to the cell pitch P1 is greater than or equal to 3 (i.e., L1/P1 $\geq$ 3).

In some embodiments, the first interconnection-level conductive trace Mtop has openings 250 passing through the first interconnection-level conductive trace Mtop. The openings 250 may allow a light 400 to penetrate through them and irradiate the electronic devices 220. The openings 250 are periodically arranged along the direction 100 and the direction 110 to the exposed portions of the electronic devices 220, especially the gate electrodes disposed in the gate oxide (GOX) charging sensitive regions. For example, at least some of the gate structures 210-1 of the floating gate transistors 220T1 of the electronic devices 220 may be exposed from the openings 250. The others of the gate structures 210-1 may be located between the exposed gate structures 210-1 and fully covered by the first interconnection-level conductive trace Mtop. In addition, the gate electrodes not disposed in the gate oxide (GOX) charging sensitive regions may be exposed from the openings 250. For example, there might be some of the gate structures 210-2 of the select transistors 220T2 exposed from the openings 250. The others of the gate structures 210-2 may be located between the exposed gate structures 210-1 and 210-2 and covered by the first interconnection-level conductive trace Mtop.

In some embodiments, a space S1 between the two adjacent openings 250 (or a minimum space S1 between the opening 250 and the outer edge E1 of the first interconnection-level conductive trace Mtop) in the direction 100 may satisfy Equation (1):

$$S1 = m\lambda(D1/A1) \qquad \text{Equation (1)}$$

wherein S1 is the space between the two adjacent openings 250 (or the minimum space between the opening 250 and the outer edge E1 of the first interconnection-level conductive trace Mtop) D1 is a distance between the first interconnection-level conductive trace Mtop and the electronic devices 220 in the direction 120, A1 is a dimension of the opening 250 (or a space between the two adjacent topmost interconnection-level conductive traces Mtop) in the direction 100, $\lambda$ is the wavelength of the light 400, and m is greater than 1 and less than 3 (i.e., 1 < m < 3).

In some embodiments, D1 is the distance between the first interconnection-level conductive trace Mtop and the floating gate transistors 220T1 of the electronic devices 220 in the direction 120. In addition, the distance D1 between the first interconnection-level conductive trace Mtop and the floating gate transistors 220T1 of the electronic devices 220 in the direction 120 is much greater than the dimension A1 of the opening 250. In some embodiments, the light 400 is ultraviolet (UV) light. In other words, the wavelength $\lambda$ of the light 400 may be between 10 nm and 400 nm. In some embodiments, the dimension A1 of the opening 250 is proportional to a dimension L2 of the gate structure 210-1 of the floating gate transistor 220T1 of the electronic devices 220 in the direction 100. In some embodiments, the dimension A1 of the opening 250 is greater than or equal to the dimension L2 of the gate structure 210-1 of the floating gate transistor 220T1 of the electronic devices 220. In addition, the dimension A1 of the opening 250 is greater than or equal to the wavelength $\lambda$ of the light 400. For example, when the light 400 is ultraviolet (UV) light, the dimension A1 of the opening 250 may be between 0.1 $\mu$m and 5 $\mu$m. Therefore, the light 400 may directly pass through the opening 250 or form a diffraction pattern.

In some embodiments, when the m is greater than 1 and less than 3, the density of the openings 250 may be sufficient to maintain the first interconnection-level conductive trace Mtop at a low resistance, thereby preventing electromigration (EM). Additionally, this range allows an adequate amount of light 400 to penetrate the first interconnection-level conductive trace Mtop and irradiate the electronic devices 220, thereby supporting light penetration capability (e.g., UV erase capability).

When the dimension A1 of the opening 250 is substantially equal to (comparable to) the wavelength $\lambda$

of the light 400, the light 400 passing through the opening 250 forms a diffraction pattern. In some embodiments, the space S1 between the two adjacent openings 250 (or the minimum space S1 between the opening 250 and the outer edge E1 of the first interconnection-level conductive trace Mtop) in the direction 100 may be located directly above the dark fringe position (e.g., the second dark fringe position when m is equal to 2) in the diffraction pattern of the light 400 through the adjacent opening 250. The openings 250 of the first interconnection-level conductive trace Mtop may be arranged with the space S1 to make sure that all the floating gate transistors 220T1 of the electronic devices 220 are exposed to the incident light 400 or the diffraction of the light 400.

In some embodiments, the openings 250 are arranged with a pitch P2 in the direction 100. The pitch P2 of the openings 250 is slightly greater than the space S1 between the two adjacent openings 250. In some embodiments, a ratio of the pitch P2 (or the space S1) to the cell pitch P1 is between 1 and 2 (i.e., $1 \leq P2/P1$ (or $S1/P1) \leq 2$). When the ratio of the pitch P2 (or the space S1) to the cell pitch P1 is between 1 and 2, the arrangement helps ensure that the electronic devices 220 are not positioned at the dark fringe positions in the diffraction patterns of the light 400 passing through the corresponding openings 250. This configuration supports effective light penetration capability (e.g., UV erase capability).

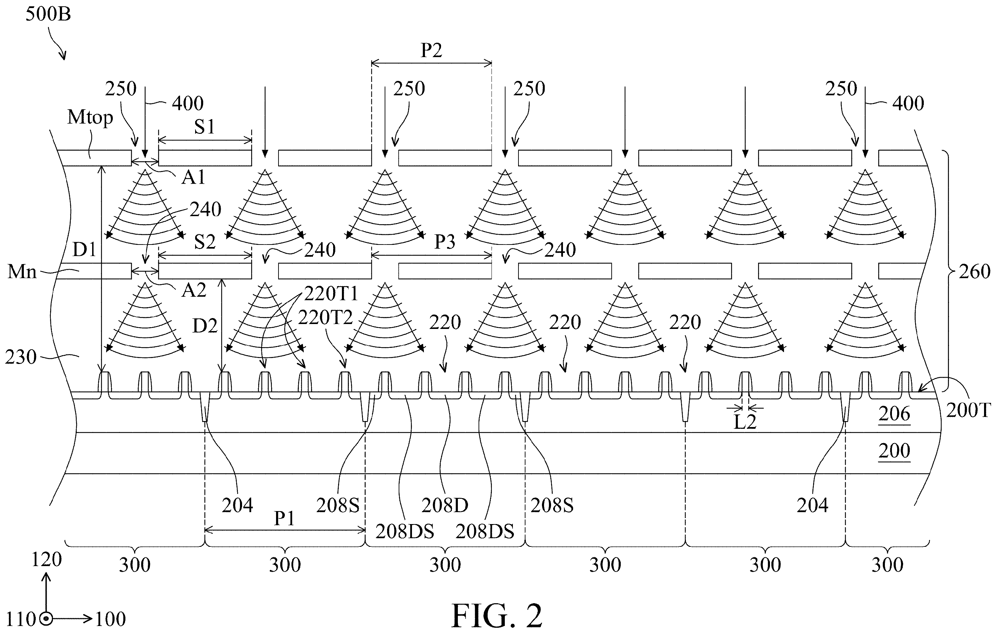

FIG. 2 is a schematic cross-sectional view of a semiconductor structure 500B in accordance with some embodiments of the disclosure. FIG. 3 is also a schematic top view of the semiconductor structure 500B of FIG. 2 in accordance with some embodiments of the disclosure, showing the arrangements of openings 240 of a second interconnection-level conductive trace Mn of the interconnection structure 260 and the relative positions between the openings 240 of the second interconnection-level conductive trace Mn and the gate structures 210-1 of electronic devices 220. FIG. 3 only show some features for illustration, and the remaining features may be shown in the cross-sectional views of FIG. 1. Elements of the embodiments hereinafter, that are the same or similar as those previously described with reference to FIG. 1 are not repeated for brevity. In this embodiment, the second interconnection-level conductive trace Mn includes any of 1st interconnection-level conductive trace (M1), 2nd interconnection-level conductive trace (M2) through the one layer below to top interconnection-level conductive trace (Mtop-1). In some embodiments, the interconnection structure 260 includes multiple trace layers, such as the first interconnection-level conductive trace Mtop, the 1st interconnection-level conductive trace (M1) closest to the electronic device 220, and other trace layers located between the first interconnection-level conductive trace Mtop and the 1st interconnection-level conductive trace (M1). In some embodiments, the multiple openings (such as the openings 250) can be provided only in the first interconnection-level conductive trace Mtop (which serves as the topmost trace layer). This allows light 400 to smoothly pass through the relatively wide first interconnection-level conductive trace Mtop and reach the gate structures 210-1. In this embodiment, the first interconnection-level conductive trace Mtop, as the topmost trace layer, can be the widest trace among all the trace layers in the interconnection structure 260. In this embodiment, the 1st interconnection-level conductive trace (M1) and other trace layers may not necessarily have such openings. In some embodiments, in addition to providing multiple openings in the first interconnection-level conductive trace Mtop, such openings can also be provided in the 1st interconnection-level conductive trace (M1) and/or other trace layers (for example, when the traces of the 1st interconnection-level conductive trace (M1) and/or other trace layers are relatively wide), thereby allowing light 400 to smoothly reach the gate structures 210-1. Therefore, in some embodiments, openings can be provided at least in the first interconnection-level conductive trace Mtop of the interconnection structure 260. Of course, the openings can also be provided in the trace of other different layers as needed. In some embodiments, since the trace with the openings is located directly above the gate structures 210-1, the trace does not need to be arranged offset from the gate structures 210-1, thereby avoiding an increase in the area occupied by the semiconductor structure and reducing the complexity of wiring. Moreover, in this embodiment, light 400 can be used to irradiate after the interconnection structure 260 is formed, to eliminate excess charges in the gate oxide of the gate structures 210-1, thereby facilitating manufacturing and simplifying the manufacturing process.

As shown in FIG. 2, the difference between the semiconductor structure 500A and the semiconductor structure 500B is that the semiconductor structure 500B further includes the second interconnection-level conductive trace Mn disposed overlapping the first interconnection-level conductive trace Mtop in the direction 120. In this embodiment, the second interconnection-level conductive trace Mn is disposed directly below the first interconnection-level conductive trace Mtop. As shown in FIGS. 2 and 3, the second interconnection-level conductive trace Mn may be located directly above and covering the electronic devices 220. In some embodiments, the second interconnection-level conductive trace Mn has a dimension L3 in the direction 100. In some embodiments, a ratio of the dimension L3 to the cell pitch P1 is between 1 and 3 (i.e., $1 \leq L3/P1 \leq 3$). The electronic devices 220 may be located partially or fully within a projection of an outer edge E2 of the second interconnection-level conductive trace Mn on the top surface 200T of the substrate 200. In some embodiments, the number of the electronic devices 220 fully within the projection of the outer edge E2 may be less than the number of the electronic devices 220 within the projection of the projection of the outer edge E1.

As shown in FIGS. 2 and 3, the second interconnection-level conductive trace Mn has openings 240 through the tower interconnection-level conductive trace Mn. In some embodiments, the openings 240 of the second interconnection-level conductive trace Mn are aligned with the corresponding openings 250 of the first interconnection-level conductive trace Mtop in the direction 120. The openings 240 are periodically arranged along the direction 100 and the direction 110 to the exposed portions of the electronic devices 220, especially the gate electrodes disposed in the gate oxide (GOX) charging sensitive regions. For example, some of the gate structures 210-1 of the floating gate transistors 220T1 of the electronic devices 220 may be exposed from the openings 240. The others of the gate structures 210-1 may be located between the exposed gate structures 210-1 and fully covered by the second interconnection-level conductive trace Mn. In addition, the gate electrodes not disposed in the gate oxide (GOX) charging sensitive regions may be exposed from the openings 240. For example, there might be some of the gate structures 210-2 of the select transistors 220T2 exposed from the openings 240. The others of the gate structures 210-2 may be located between the exposed gate structures 210-1 and 210-2 and covered by the second interconnection-level conductive trace Mn. In addition, in some embodiments, the number of the gate structures (the gate structure 210-1 or 210-2) exposed from the openings 240 may be one.

In some embodiments, a space S2 between the two adjacent openings 240 (or a minimum space S2 between the opening 240 and the outer edge E2 of the second interconnection-level conductive trace Mn) in the direction 100 may satisfy Equation (2):

$$S2 = p\lambda(D2/A2) \qquad \text{Equation (2)}$$

wherein S2 is the space between the two adjacent openings 240 (or the minimum space between the opening 240 and the outer edge E2 of the second interconnection-level conductive trace Mn), D2 is a distance between the second interconnection-level conductive trace Mn and the electronic devices 220 in the direction 120, A2 is a dimension of the opening 240 (or a space between the two adjacent second interconnection-level conductive traces Mn in the direction 100), $\lambda$ is the wavelength of the light 400, and p is greater than 1 and less than 3 (i.e., $1 < p < 3$).

In some embodiments, D2 is the distance between the second interconnection-level conductive trace Mn and the floating gate transistors 220T1 of the electronic devices 220 in the direction 120. In addition, the distance D2 between the second interconnection-level conductive trace Mn and the floating gate transistors 220T1 of the electronic devices 220 in the direction 120 is much greater than the dimension A2 of the opening 240. Furthermore, the distance D2 may be smaller than the distance D1. In some embodiments in which the light 400 is ultraviolet (UV) light, $\lambda$ of the light 400 may be between 10 nm and 400 nm. In some embodiments, the dimension A2 of the opening 240 is proportional to the dimension L2 of the gate structure 210-1 of the floating gate transistor 220T1 of the electronic devices 220 in the direction 100. In some embodiments, the dimension A2 of the opening 240 is greater than or equal to the dimension L2 of the gate structure 210-1 of the floating gate transistor 220T1 of the electronic devices 220. In addition, the dimension A2 of the opening 240 is greater than or equal to the wavelength $\lambda$ of the light 400. For example, when the light 400 is ultraviolet (UV) light, the dimension A2 of the opening 240 may be between 0.1 $\mu$m and 5 $\mu$m. Therefore, the light 400 may pass through the opening 240 with or without forming a diffraction pattern.

In some embodiments, when the p is greater than 1 and less than 3, the density of the openings 240 may be sufficient to maintain the first interconnection-level conductive trace Mtop at a low resistance, thereby preventing electromigration (EM). Additionally, this range allows an adequate amount of light 400 to penetrate the first interconnection-level conductive trace Mtop and irradiate the electronic devices 220, thereby supporting light penetration capability (e.g., UV erase capability).

When the dimension A2 of the opening 240 is substantially equal to (or comparable to) the wavelength $\lambda$ of the light 400, the light 400 passing through the opening 240 forms a diffraction pattern. In some embodiments, the space S2 between the two adjacent openings 240 (or the minimum space S2 between the opening 240 and the outer edge E2 of the second interconnection-level conductive trace Mn) in the direction 100 may be located directly above the dark fringe position (e.g., the second dark fringe position when p is equal to 2) in the diffraction pattern of the light 400 through the adjacent opening 240. The openings 240 of the second interconnection-level conductive trace Mn may be arranged with the space S2 to make sure that all the floating gate transistors 220T1 of the electronic devices 220 are exposed to the incident light 400 or the diffraction of the light 400.

In some embodiments, the openings 240 are arranged with a pitch P3 in the direction 100. The pitch P3 of the openings 240 is slightly less than the space S2 between the two adjacent openings 240. In some embodiments, the pitch P3 may be the same as the pitch P2. In some embodiments, the pitch P2 may be an integer multiple of the pitch P3 or vice versa, depending on the dimensions A1, A2 and the distances D1, D2. In some embodiments, a ratio of the pitch P3 (or the space S2) to the cell pitch P1 is between 1 and 2 (i.e., $1 \leq P3/P1$ (or $S2/P1) \leq 2$). When the ratio of the pitch P3 (or the space S2) to the cell pitch P1 is between 1 and 2, the arrangement helps ensure that the electronic devices 220 are not positioned at the dark fringe positions in the diffraction patterns of the light 400 passing through the corresponding openings 250. This configuration supports effective light penetration capability (e.g., UV erase capability).

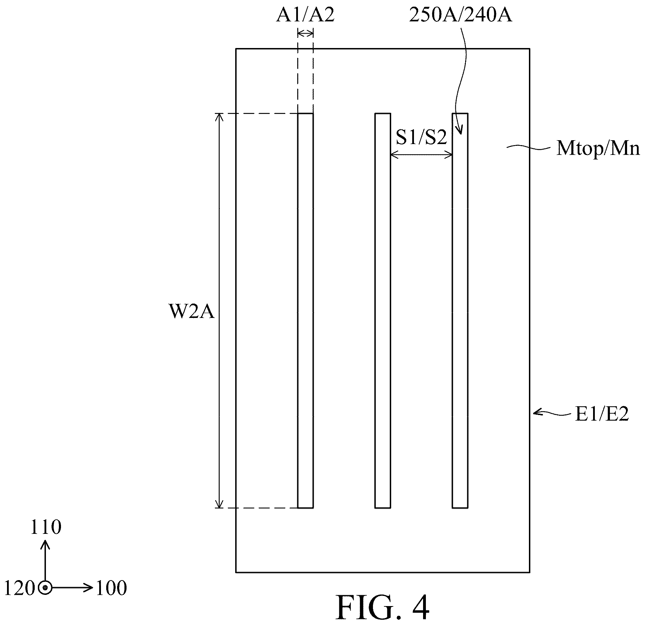

FIGS. 4, 5, 6, 7 and 8 are schematic top views of the first interconnection-level conductive trace Mtop (or the second interconnection-level conductive trace Mn) of the semiconductor structure 500A of FIG. 1 (or the semiconductor structure 500B of FIG. 2) in accordance with some embodiments of the disclosure, showing various shapes of the openings 250 of the first interconnection-level conductive trace Mtop (or the openings 240 of the second interconnection-level conductive trace Mn) of the interconnection structure 260.

In some embodiments, the dimension L1 (FIG. 3) of the first interconnection-level conductive trace Mtop in the direction 100 is greater than 10 μm, which is much greater than much greater than the dimension A1 (e.g., between 0.1 μm and 5 μm) of the opening 250 (or the dimension A2 (e.g., between 0.1 μm and 5 μm) of the opening 240) in the direction 100. In some embodiments, the openings 250 of the first interconnection-level conductive trace Mtop (or the openings 240 of the second interconnection-level conductive trace Mn) of the interconnection structure 260 may be separated from each other and have various shapes in the top view.

As shown in FIG. 4, the first interconnection-level conductive trace Mtop (or the second interconnection-level conductive trace Mn) may have strip-shaped openings 250A (or openings 240A) arranged along the direction 100 and extending along the direction 110. Therefore, the direction 110 may also be the direction in which the corresponding gate structures 210-1 extend. In some embodiments, the strip-shaped openings 250A (or the openings 240A) and the gate structures 210-1 exposed from the corresponding strip-shaped openings 250A (or the openings 240A) are in a one-to-many relationship or a one-to-one relationship. In some embodiments, the openings 250A (or the openings 240A) and the gate structures 210-1 located within the vertical projection area of the openings 250A (or the openings 240A) can have a one-to-many relationship or a one-to-one relationship. FIG. 3 also illustrates the relative positions between the openings 250A of the first interconnection-level conductive trace Mtop (or the openings 240A of the second interconnection-level conductive trace Mn) and the floating gate transistor 220T1 of the electronic devices 220. For example, in the top view as shown in FIG. 3, when a dimension W1 of the gate structures 210-1 of the floating gate transistor 220T1 of the electronic devices 220 is smaller than a dimension W2A of the strip-shaped openings 250A (or the openings 240A) in the direction 110, each of the strip-shaped openings 250A (or the openings 240A) and the gate structures 210-1 exposed from the corresponding strip-shaped openings 250A (or the openings 240A) may be in one-to-many relationship. If the dimension W1 of the gate structures 210-1 is comparable to the dimension W2A of the strip-shaped openings 250A (or the openings 240A) in the direction 110 each of the strip-shaped openings 250A (or the openings 240A) and the gate structures 210-1 exposed from the corresponding strip-shaped openings 250A (or the openings 240A) may be in one-to-one relationship. In some embodiments, in the top view, each of the openings 250A (or the openings 240A) may expose at least one gate structure (the gate structure 210-1 or 210-2). Alternatively, at least one gate structure (the gate structure 210-1 or 210-2) may be exposed from each of the openings 250A (or the openings 240A) when viewed from the top.

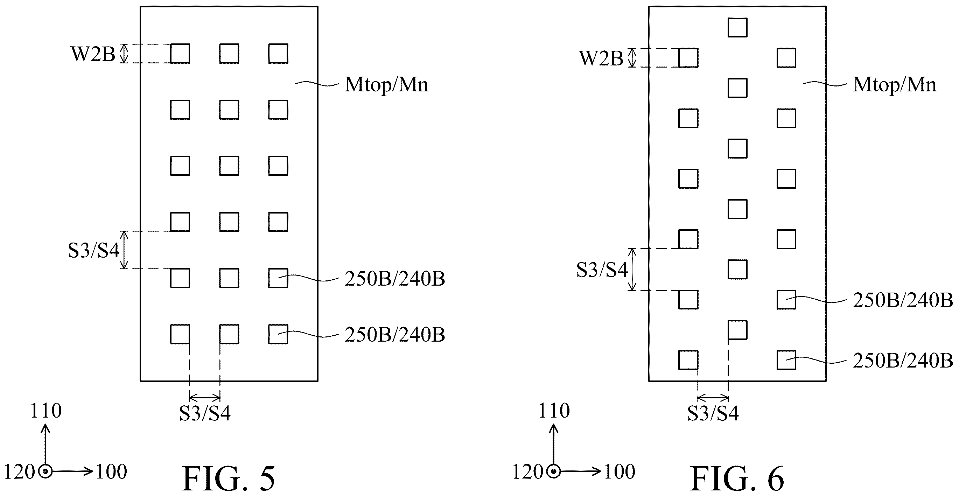

As shown in FIG. 5, the first interconnection-level conductive trace Mtop (or the second interconnection-level conductive trace Mn) may have square-shaped openings 250B (or openings 240B) periodically arranged as an array along the direction 100 and the direction 110. In some embodiments, the square-shaped openings 250B (or openings 240B) in the adjacent rows are aligned with each other along the direction 100. In addition, the square-shaped openings 250B (or openings 240B) may be arranged in multi rows along the extending direction of the corresponding gate structures 210-1 (e.g., the direction 110). In some embodiments, a space S3 between the two adjacent openings 250B (or a space S4 between the two adjacent openings 240B) in the direction 110 may be the same as or different from the space S1 (or the space S2) in the direction 100.

In some embodiments, in the top view as shown in FIGS. 2 and 5, when the dimension W1 (FIG. 2) of the gate structures 210-1 of the floating gate transistor 220T1 of the electronic devices 220 is greater than a dimension W2B of the square-shaped openings 250B (or the openings 240B) in the direction 110, each of the square-shaped openings 250B (or the openings 240B) and the gate structures 210-1 exposed from the corresponding strip-shaped openings 250B (or the openings 240B) may be in one-to-one relationship. In some embodiments, in the top view, each of the openings 250B (or the openings 240B) may expose at least one gate structure (the gate structure 210-1 or 210-2).

As shown in FIG. 6, the first interconnection-level conductive trace Mtop (or the second interconnection-level conductive trace Mn) may have square-shaped openings 250B (or openings 240B) periodically arranged along the direction 100 and the direction 110. The differences between the first interconnection-level conductive trace Mtop (or the second interconnection-level conductive trace Mn) in FIGS. 5 and 6 is that the square-shaped openings 250B (or openings 240B) in the adjacent rows are alternately arranged along the extending direction of the gate structures 210-1 (e.g., the direction 110). Similar to the first interconnection-level conductive trace Mtop (or the second interconnection-level conductive trace Mn) in FIG. 5, each of the square-shaped openings 250B of the first interconnection-level conductive trace Mtop (or the openings 240B of the second interconnection-level conductive trace Mn) and the gate structures 210-1 exposed from the corresponding square-shaped openings 250B (or the openings 240B) may be in one-to-one relationship in FIG. 6. As shown in FIGS. 5 and 6, the openings 250B (or openings 240B) are distributed in different rows (or columns), and the openings 250B (or openings 240B) in different rows or columns can be arranged side by side or in a staggered manner. In some embodiments, the openings 250B (or openings 240B) can also be arranged in other ways to form the desired array or pattern.

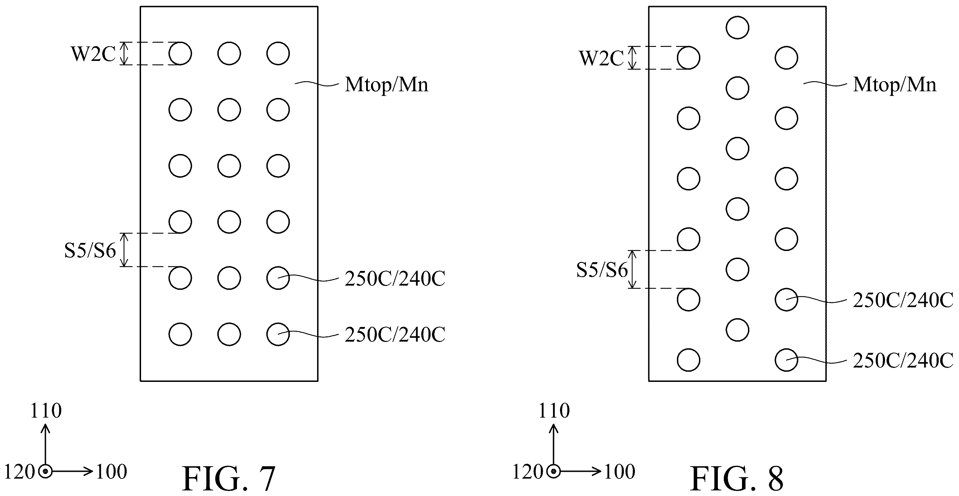

As shown in FIG. 7, the first interconnection-level conductive trace Mtop (or the second interconnection-level conductive trace Mn) may have circular-shaped openings 250C (or openings 240C) periodically arranged as an array along the direction 100 and the direction 110. In some embodiments, the circular-shaped openings 250C (or openings 240C) in the adjacent rows are aligned with each other along the direction 100. The differences between the first interconnection-level conductive trace Mtop (or the second interconnection-level conductive trace Mn) in FIGS. 5 and 7 is that the openings 250C (or openings 240C) are circular-shaped.

In some embodiments, the circular-shaped openings 250C (or openings 240C) in the adjacent rows are aligned with each other along the direction 100. In addition, the square-shaped openings 250C (or openings 240C) may be arranged in multi rows along the extending direction of the corresponding gate structures 210-1 (e.g., the direction 110). In some embodiments, a space S5 between the two adjacent openings 250C (or a space S6 between the two adjacent openings 240C) in the direction 110 may be the same as or different from the space S1 (or the space S2) in the direction 100.

In some embodiments, in the top view as shown in FIG. 7, when the dimension W1 (FIG. 2) of the gate structures 210-1 of the floating gate transistor 220T1 of the electronic devices 220 is greater than a dimension W2C of the circular-shaped openings 250C (or the openings 240C) in the direction 110, each of the circular-shaped openings 250C (or the openings 240C) and the gate structures 210-1 exposed from the corresponding circular-shaped openings 250C (or the openings 240C) may be in one-to-one relationship. In some embodiments, in the top view, each of the openings 250C (or the openings 240C) may expose at least one gate structure (the gate structure 210-1 or 210-2).

As shown in FIG. 8, the first interconnection-level conductive trace Mtop (or the second interconnection-level conductive trace Mn) may have circular-shaped openings 250C (or openings 240C) periodically arranged along the direction 100 and the direction 110. The differences between the first interconnection-level conductive trace Mtop (or the second interconnection-level conductive trace Mn) in FIGS. 7 and 8 is that the circular-shaped openings 250C (or openings 240C) in the adjacent rows are alternately arranged along the extending direction of the gate structures 210-1 (e.g., the direction 110). Similar to the first interconnection-level conductive trace Mtop (or the second interconnection-level conductive trace Mn) in FIG. 7, each of the circular-shaped openings 250C of the first interconnection-level conductive trace Mtop (or the openings 240C the second interconnection-level conductive trace Mn) and the gate structures 210-1 exposed from the corresponding circular-shaped openings 250C (or the openings 240C) may be in one-to-one relationship in FIG. 8.

In some embodiments, when the openings 250 (or the openings 240) are arranged in multi rows along the extending direction of the corresponding gate structures 210-1 (e.g., the direction 110) (similar to the arrangements in FIG. 5 or FIG. 6), the openings 250 (or the openings 240) may be oval, polygonal or another applicable shape. It should be noted that the shape of the openings 250 (or the openings 240) not limited to the disclosed embodiments.

In some embodiments, the adjacent openings 250 of the first interconnection-level conductive trace Mtop (or the openings 240 of the second interconnection-level conductive trace Mn) in the direction 100 may have different shapes or different dimensions along the direction 110.

For example, as shown in FIG. 4, one or more strip-shaped openings 250A (or the openings 240A) may be replaced by a single row or multi rows of the openings 250B (or the openings 240B) or the openings 250C (or the openings 240C) shown in FIGS. 5 to 8. Alternatively, one or more strip-shaped openings 250A (or the openings 240A) may be replaced by a single row or multi rows of the openings 250 (or the openings 240) having an oval-shape, a polygonal-shape or another applicable shape.

For example, as shown in FIG. 4, one or more strip-shaped openings 250A (or the openings 240A) having the dimension W2A along the direction 110 may be replaced by single or multi rows of the openings 250B (or the openings 240B) or the openings 250C (or the openings 240C) having the dimension W2B (or the dimension W2C) along the direction 110 that is smaller than the dimension W2A.

For example, as shown in FIGS. 5 and 6, a single row or multi rows of the square-shaped openings 250B (or the openings 240B) may be replaced by a single row or multi rows of the circular-shaped openings 250C (or the openings 240C). Alternatively, a single row or multi rows of the square-shaped openings 250B (or the openings 240B) may be replaced by single or multi rows of the openings 250 (or the openings 240) having an oval-shape, a polygonal-shape or another applicable shape.

In some embodiments, the openings 250 (or the openings 240) in the same row may have different shapes.

For example, the openings 250 (or the openings 240) in the same row may be composed of any combination of the square-shaped openings 250B (or the openings 240B) and circular-shaped openings 250C (or the openings 240C) and the openings 250 (or the openings 240) having an oval-shape, a polygonal-shape or another applicable shape.

In some embodiments, the openings 250 of the first interconnection-level conductive trace Mtop and the openings 240 of the second interconnection-level conductive trace Mn may have different shapes or different dimensions along the direction 110.

For example, the openings 250 of the first interconnection-level conductive trace Mtop may be strip-shaped (e.g., the strip-shaped openings 250A), and the openings 240 of the second interconnection-level conductive trace Mn may be circular, oval, polygonal or another applicable shape (e.g., the square-shaped openings 240B or the circular-shaped openings 240C).

For example, the openings 250 of the first interconnection-level conductive trace Mtop may be square-shaped (e.g., the square-shaped openings 240B), and the openings 240 of the second interconnection-level conductive trace Mn may be strip-shaped, circular, oval, polygonal or another applicable shape (e.g., the strip-shape openings 250A or the circular-shaped openings 240C).

For example, the first interconnection-level conductive trace Mtop may have the openings 250A having the dimension W2A along the direction 110, and the second interconnection-level conductive trace Mn may have the openings 240B having the dimension W2B (or the openings 240C having the dimension W2C) along the direction 110 corresponding to the strip-shaped openings 250A.

Embodiments provide a semiconductor structure that allows the metal routings arranged above the gate oxide (GOX) sensitive regions of the semiconductor devices. The semiconductor structure includes a substrate, electronic devices, and an interconnection structure. The electronic devices are disposed on the substrate. The electronic devices includes first gate structures. The interconnection structure including a first interconnection-level conductive trace is located directly above the electronic devices. The first interconnection-level conductive trace has first openings (e.g., slots or holes) for exposing at least one of the first gate structures.

In some embodiments, a first space S1 between the two adjacent first openings in a first direction satisfies Equation (1):

$$S1 = m\lambda(D1/A1) \qquad \text{Equation (1)}$$

wherein S1 is the first space between the two adjacent first openings, D1 is the first distance between the first interconnection-level conductive trace and the electronic devices in the second direction, A1 is the dimension of the first opening in the first direction, $\lambda$ is the wavelength of the light, and m is greater than 1 and less than 3.

In some embodiments, the first interconnection-level conductive trace is the topmost interconnection-level conductive trace and the light is UV light. In addition, the first dimension A1 of the first openings is greater than or equal to the wavelength $\lambda$ of UV light.

In some embodiments, the electronic devices are located within a projection of an outer edge of the first interconnection-level conductive trace on the top surface of the substrate. In some embodiments, in the first direction, the electronic devices are arranged with a cell pitch, and the ratio of the first space to the cell pitch is between 1 and 2. In some embodiments, in the first direction, the electronic devices are arranged with a cell pitch, the first openings are arranged with a first pitch, and the ratio of the first pitch to the cell pitch is between 1 and 2. In some embodiments, the electronic devices comprise first gate structures having a third dimension along the first direction, and the first dimension is greater than or equal to the third dimension.

In some embodiments, each of the electronic devices includes a floating gate transistor and a floating gate transistor. The floating gate transistor is disposed on a first well region in the substrate. The floating gate transistor includes the first gate structure and a first source/drain doped region and a second source/drain doped region disposed on the first well region and on opposite sides of the first gate structure. The select transistor is disposed on a first well region. The select transistor includes a second gate structure, the second source/drain doped region and a third source/drain doped region. The second gate structure is located beside the first gate structure of the floating gate transistor. The second source/drain doped region and a third source/drain doped region are disposed on the first well region and on opposite sides of the second gate structure.

In some embodiments, some of the second gate structures of the electronic devices are exposed from the first openings. In some embodiments, the number of the second gate structures of the electronic devices exposed from the first openings may be one. In some embodiments, the first openings extend along the extending direction of the corresponding first gate structures. In some embodiments, the first openings are arranged in rows along the extending direction of the corresponding first gate structures. In some embodiments, the first openings in the adjacent rows are alternately arranged along the extending direction of the corresponding first gate structures. In some embodiments, the first openings in the adjacent rows are aligned with each other along the first direction. In some embodiments, in the top view, the first openings and the first gate structures exposed from the corresponding first openings are in a one-to-many relationship or a one-to-one relationship. In some embodiments, in the top view, each of the first openings may expose at least one gate structure. In some embodiments, the first openings are strip-shaped, square-shaped, circular-shaped, oval-shaped, or polygonal-shaped.

In some embodiments, the interconnection structure of the semiconductor structure further includes a second interconnection-level metal layer overlapping the first interconnection-level metal layer. The second interconnection-level metal layer may has second openings aligned with the corresponding first openings in the second direction. In some embodiments, the second interconnection-level metal layer is located directly above or below the first interconnection-level conductive trace. For example, when the first interconnection-level conductive trace is the topmost interconnection-level conductive trace, the second interconnection-level conductive trace is the lower interconnection-level conductive trace. Alternatively, when the first interconnection-level conductive trace is the lower interconnection-level conductive trace, the second interconnection-level conductive trace is the topmost interconnection-level conductive trace.

In some embodiments, a second space S2 between the two adjacent second openings in the first direction satisfies Equation (2):

$$S2=p\lambda(D2/A2) \quad \text{Equation (2)}$$

wherein S2 is the second space between the two adjacent second openings in the first direction, D2 is a second distance between the lower interconnection-level conductive trace and the electronic devices in the second direction, A2 is the dimension of the second opening in the first direction, $\lambda$ is the wavelength of light, and p is greater than 1 and less than 3.

Similarly to the first interconnection-level conductive trace, the dimension A2 of the second openings is greater than or equal to the wavelength $\lambda$ of UV light. In some embodiments, the first openings of the first interconnection-level conductive trace and the second openings of the second interconnection-level conductive trace may have different shapes. In addition, the dimension A1 of the first openings may be different from the dimension A2 of the second openings.

According to the arrangements of the openings of the interconnection-level conductive trace, especially the openings arranged in the topmost interconnection-level conductive trace, the charges trapped in the gate oxide of the electronic devices can be removed by incident UV light or a diffraction of UV light passing through the openings even the topmost interconnection-level conductive trace is disposed directly above and fully covering the electronic devices. By utilizing light diffraction property, the dimension of the openings can be minimized (e.g., comparable to the wavelength $\lambda$ of UV light) to reduce impact on resistance and electro-migration penalty on the interconnection-level conductive trace.

While the disclosure has been described by way of example and in terms of the preferred embodiments, it should be understood that the disclosure is not limited to the disclosed embodiments. On the contrary, it is intended to cover various modifications and similar arrangements (as would be apparent to those skilled in the art). Therefore, the scope of the appended claims should be accorded the broadest interpretation so as to encompass all such modifications and similar arrangements.

The present invention may also be defined by the following numbered clauses.

1. A semiconductor structure, comprising:

a substrate;
electronic devices disposed on the substrate, wherein the electronic devices comprise first gate structures; and
an interconnection structure comprising a first interconnection-level conductive trace located directly above the electronic devices, wherein the first interconnection-level conductive trace has first openings for exposing at least one of the first gate structures.

2. The semiconductor structure as claimed in clause 1, wherein a first space between the two adjacent first openings in a first direction satisfies Equation (1):

$$S1=m\lambda(D1/A1) \quad \text{Equation (1)}$$

wherein S1 is the first space between the two adjacent first openings,
D1 is a first distance between the first interconnection-level conductive trace and the electronic devices in a second direction,
A1 is a first dimension of the first opening in the first direction,
$\lambda$ is the wavelength of the light, and
m is greater than 1 and less than 3.

3. The semiconductor structure as claimed in clause 2, wherein A1 is greater than or equal to $\lambda$.

4. The semiconductor structure as claimed in claim 1, wherein the first interconnection-level conductive trace is a topmost interconnection-level conductive trace.

5. The semiconductor structure as claimed in clause 1, wherein the electronic devices are located within a projection of an outer edge of the first interconnection-level conductive trace on a top surface of the substrate.

6. The semiconductor structure as claimed in clause 2, wherein in the first direction, the electronic devices are arranged with a cell pitch, and a ratio of the first space to the cell pitch is between 1 and 2.

7. The semiconductor structure as claimed in clause 1, wherein in the first direction, the electronic devices are arranged with a cell pitch, the first openings are arranged with a first pitch, and a ratio of the first pitch to the cell pitch is between 1 and 2.

8. The semiconductor structure as claimed in clause 2, wherein the first gate structures having a second dimension along the first direction, and the first dimension is greater than or equal to the second dimension.

9. The semiconductor structure as claimed in clause 1, wherein each of the electronic devices comprises:
a floating gate transistor disposed on a first well region in the substrate, wherein the floating gate transistor comprises:

one of the first gate structures; and
a first source/drain doped region and a second source/drain doped region disposed on the first well region and on opposite sides of the first gate structure;
a select transistor disposed on the first well region, wherein the select transistor comprises:

a second gate structure located beside the first gate structure of the floating gate transistor; and
a third source/drain doped region and the first source/drain doped region disposed on the first well region and on opposite sides of the second gate structure.

10. The semiconductor structure as claimed in clause 9, wherein at least one of the second gate structures of the electronic devices are exposed from the first openings.

11. The semiconductor structure as claimed in clause 1, wherein the first openings extend along an extending direction of the corresponding first gate structures.

12. The semiconductor structure as claimed in clause 1, wherein the first openings are arranged in rows along an extending direction of the corresponding first gate structures.

13. The semiconductor structure as claimed in clause 12, wherein the first openings in the adjacent rows are alternately arranged along the extending direction of the corresponding first gate structures.

14. The semiconductor structure as claimed in clause 2, wherein the first openings in the adjacent rows are aligned with each other along the first direction.

15. The semiconductor structure as claimed in clause 12, wherein in a top view, the first openings and the first gate structures exposed from the corresponding first openings are in a one-to-many relationship or a one-to-one relationship.

16. The semiconductor structure as claimed in clause 1, wherein the first openings are strip-shaped, square-shaped, circular-shaped, oval-shaped, or polygonal-shaped.

17. The semiconductor structure as claimed in clause 2, wherein the interconnection structure further comprises:
a second interconnection-level conductive trace overlapping the first interconnection-level conductive trace, wherein the second interconnection-level conductive trace has second openings aligned with the corresponding first openings in the second direction.

18. The semiconductor structure as claimed in clause 17, wherein a second space between the two adjacent second openings in the first direction satisfies Equation (2):

$$S2 = p\lambda\,(D2/A2) \qquad \text{Equation (2)}$$

wherein S2 is the second space between the two adjacent second openings in the first direction,
D2 is a second distance between the second interconnection-level conductive trace and the electronic devices in the second direction,
A2 is a third dimension of the second opening in the first direction,
$\lambda$ is the wavelength of light, and
p is greater than 1 and less than 3.

19. The semiconductor structure as claimed in clause 17, wherein the second interconnection-level conductive trace is located directly above or below the first interconnection-level conductive trace.

## Claims

1. A semiconductor structure (500A, 500B), comprising:

a substrate (200);
electronic devices (220) disposed on the substrate, wherein the electronic devices comprise first gate structures (210-1); and
an interconnection structure (260) comprising a first interconnection-level conductive trace (Mtop, Mn) located directly above the electronic devices, wherein the first interconnection-level conductive trace has first openings (250, 250A, 250B, 250C) for exposing at least one of the first gate structures.

2. The semiconductor structure as claimed in claim 1, wherein a first space (S1, S2) between the two adjacent first openings in a first direction (100) satisfies Equation (1):

$$S1 = m\lambda(D1/A1) \qquad \text{Equation (1)}$$

wherein S1 is the first space between the two adjacent first openings,
D1 is a first distance between the first interconnection-level conductive trace and the electronic devices in a second direction (120),
A1 is a first dimension of the first opening in the first direction,
$\lambda$ is the wavelength of the light, and
m is greater than 1 and less than 3.

3. The semiconductor structure as claimed in claim 2, wherein A1 is greater than or equal to $\lambda$.

4. The semiconductor structure as claimed in claim 1, wherein the first interconnection-level conductive trace is a topmost interconnection-level conductive trace (Mtop).

5. The semiconductor structure as claimed in claim 1, wherein the electronic devices are located within a projection of an outer edge (E1, E2) of the first interconnection-level conductive trace on a top surface of the substrate.

6. The semiconductor structure as claimed in claim 2, wherein in the first direction, the electronic devices are arranged with a cell pitch (P1), and a ratio of the first space to the cell pitch is between 1 and 2; and/or wherein in the first direction, the electronic devices are arranged with a cell pitch (P1), the first openings are arranged with a first pitch (S1), and a ratio of the first pitch to the cell pitch is between 1 and 2.

7. The semiconductor structure as claimed in any one of claims 1 to 6, wherein each of the electronic devices comprises:

   a floating gate transistor (220T1) disposed on a first well region (206) in the substrate, wherein the floating gate transistor comprises:

   one of the first gate structures; and
   a first source/drain doped region (208DS) and a second source/drain doped region (208D) disposed on the first well region and on opposite sides of the first gate structure;

   a select transistor (220T2) disposed on the first well region, wherein the select transistor comprises:

   a second gate structure (220-2) located beside the first gate structure of the floating gate transistor; and
   a third source/drain (208S) doped region and the first source/drain doped region disposed on the first well region and on opposite sides of the second gate structure.

8. The semiconductor structure as claimed in claim 7, wherein at least one of the second gate structures (220-2) of the electronic devices are exposed from the first openings (250, 250A, 250B, 250C).

9. The semiconductor structure as claimed in claim 1, wherein the first openings (250, 250A, 250B, 250C) extend along an extending direction of the corresponding first gate structures (210-1).

10. The semiconductor structure as claimed in claim 1, wherein the first openings (250, 250A, 250B, 250C) are arranged in rows along an extending direction of the corresponding first gate structures (210-1).

11. The semiconductor structure as claimed in claim 10, wherein the first openings (250, 250A, 250B, 250C) in the adjacent rows are alternately arranged along the extending direction of the corresponding first gate structures (210-1).

12. The semiconductor structure as claimed in claim 10, wherein in a top view, the first openings (250, 250A, 250B, 250C) and the first gate structures (210-1) exposed from the corresponding first openings are in a one-to-many relationship or a one-to-one relationship.

13. The semiconductor structure as claimed in claim 1, wherein the first openings (250, 250A, 250B, 250C) are strip-shaped, square-shaped, circular-shaped, oval-shaped, or polygonal-shaped.

14. The semiconductor structure as claimed in claim 2, wherein the interconnection structure further comprises:
   a second interconnection-level conductive trace (Mtop, Mn) overlapping the first interconnection-level conductive trace, wherein the second interconnection-level conductive trace is located directly above or below the first interconnection-level conductive trace, and wherein the second interconnection-level conductive trace has second openings aligned with the corresponding first openings in the second direction.

15. The semiconductor structure as claimed in claim 14, wherein a second space (S1, S2) between the two adjacent second openings in the first direction satisfies Equation (2):

$$S2 = p\lambda(D2/A2) \qquad \text{Equation (2)}$$

   wherein S2 is the second space between the two adjacent second openings in the first direction,
   D2 is a second distance between the second interconnection-level conductive trace and the electronic devices in the second direction,
   A2 is a third dimension of the second opening in the first direction,
   $\lambda$ is the wavelength of light, and
   p is greater than 1 and less than 3.

FIG. 1

FIG. 2

FIG. 3

A1/A2

250A/240A

Mtop/Mn

S1/S2

W2A

E1/E2

110

120 → 100

# FIG. 4

W2B

Mtop/Mn

S3/S4

250B/240B

250B/240B

110

120 → 100

S3/S4

## FIG. 5

W2B

Mtop/Mn

S3/S4

250B/240B

250B/240B

110

120 → 100

S3/S4

## FIG. 6

FIG. 7

FIG. 8

EP 4 739 063 A1

Europäisches
Patentamt
European
Patent Office
Office européen
des brevets

# EUROPEAN SEARCH REPORT

**Application Number**

EP 25 20 7359

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2011/233639 A1 (YAMAKOSHI HIDEAKI [JP] ET AL) 29 September 2011 (2011-09-29) * paragraphs [0202] - [0214]; figures 45-47 * | 1-15 | INV. H10W20/41 H10B20/25 H10W20/43 H10B69/00 |
| X | US 2016/254406 A1 (LEISENBERGER FRIEDRICH PETER [AT]) 1 September 2016 (2016-09-01) * paragraphs [0063] - [0068]; figure 9 * | 1-3,5-15 | |
| X | US 7 091 088 B1 (CHENG NING [US] ET AL) 15 August 2006 (2006-08-15) * column 5, line 9 - column 10, line 19; figure 1 * | 1-3,5-15 | |
| A | US 2011/303959 A1 (MITCHELL ALLAN T [US] ET AL) 15 December 2011 (2011-12-15) * paragraphs [0038] - [0059]; figures 3-5 * | 1-15 | |

**TECHNICAL FIELDS SEARCHED (IPC)**

H10W
H10B

The present search report has been drawn up for all claims

| Place of search | Date of completion of the search | Examiner |
|---|---|---|
| The Hague | 20 March 2026 | Franche, Vincent |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

**EP 4 739 063 A1**

## ANNEX TO THE EUROPEAN SEARCH REPORT
## ON EUROPEAN PATENT APPLICATION NO.

EP 25 20 7359

This annex lists the patent family members relating to the patent documents cited in the above-mentioned European search report.
The members are as contained in the European Patent Office EDP file on
The European Patent Office is in no way liable for these particulars which are merely given for the purpose of information.

20-03-2026

| Patent document cited in search report | | Publication date | Patent family member(s) | | Publication date |
|---|---|---|---|---|---|
| US 2011233639 | A1 | 29-09-2011 | CN | 102201415 A | 28-09-2011 |
| | | | JP | 2011199124 A | 06-10-2011 |
| | | | TW | 201133803 A | 01-10-2011 |
| | | | US | 2011233639 A1 | 29-09-2011 |
| | | | US | 2014140133 A1 | 22-05-2014 |
| US 2016254406 | A1 | 01-09-2016 | EP | 2860767 A1 | 15-04-2015 |
| | | | EP | 3055888 A2 | 17-08-2016 |
| | | | US | 2016254406 A1 | 01-09-2016 |
| | | | WO | 2015052044 A2 | 16-04-2015 |
| US 7091088 | B1 | 15-08-2006 | NONE | | |
| US 2011303959 | A1 | 15-12-2011 | US | 2011303959 A1 | 15-12-2011 |
| | | | US | 2013040449 A1 | 14-02-2013 |

EPO FORM P0459

For more details about this annex : see Official Journal of the European Patent Office, No. 12/82